# FASCICULE DE BREVET EUROPEEN

(11) **EP 3 895 510 B1**
(45) Date de publication et mention de la délivrance du brevet: **16.11.2022**
(21) Numéro de dépôt: 19831786.9
(22) Date de dépôt: 19.11.2019
(51) Int. Cl.: H05K 7/14

(54) **SYSTÈME DE CONNEXION/DÉCONNEXION SÉCURISÉ DE PUISSANCE D'UN MODULE DANS UNE ALIMENTATION SANS INTERRUPTION MODULAIRE DE FORTE PUISSANCE ET INSTALLATION ASSOCIÉE**
SYSTEM ZUR SICHEREN EINSCHALTUNG/ABSCHALTUNG DES STROMS FÜR EIN MODUL IN EINER LEISTUNGSSTARKEN MODULAREN UNUNTERBROCHENEN STROMVERSORGUNG UND ZUGEHÖRIGE INSTALLATION
SYSTEM FOR SECURELY CONNECTING/DISCONNECTING POWER FOR A MODULE IN A HIGH-POWER MODULAR UNINTERRUPTABLE POWER SUPPLY AND ASSOCIATED INSTALLATION

(30) Priorité: 11.12.2018 FR 1872670
(43) Date de publication de la demande: 20.10.2021
(73) Titulaire: Socomec, 67230 Benfeld (FR)
(72) Inventeur: FRICKER, Guillaume, 68000 Colmar (FR); WILLMANN, Christian, 67230 Huttenheim (FR); ZINNI, Andréa, 67540 Ostwald (FR)
(74) Mandataire: Cabinet Beau de Loménie
(86) Numéro de dépôt international: PCT/FR2019/052740
(87) Numéro de publication internationale: WO 2020/120851

(56) Documents cités:
- EP-A1- 1 022 757
- GB-A- 2 130 021
- US-B1- 6 222 708
- US-B1- 6 392 901

## Description

### Domaine Technique

L'invention concerne les installations modulaires d'alimentation sans interruption de forte puissance, et plus particulièrement le couplage électrique d'un module de puissance d'une telle installation.

Par installation modulaire, on entend une installation qui permet de recevoir des tiroirs électriques ou modules.

### Technique antérieure

La réduction du temps d'immobilisation de l'installation dans le cas de maintenance ou d'augmentation de puissance, dénommé « Mean Time To Repair » en anglais (MTTR), est un paramètre critique dans de nombreuses applications utilisant des installations modulaires d'alimentation sans interruption (ASI).

La surface d'emprise au sol ainsi que le volume occupé par ces installations modulaires d'alimentation sans interruption est un critère important pour les utilisateurs. Les connecteurs de puissance existant dans le commerce présentent généralement des dimensions encore trop importantes.

En outre, les modules configurés pour les fortes puissances électriques présentent différents inconvénients par rapport aux modules configurés pour les faibles puissances électriques : ils sont généralement plus encombrants et plus lourds ; ils présentent un risque de formation d'arc électrique lors des connexions et déconnexions de fortes puissances ; et le risque potentiel de formation d'arc électrique entraîne des risques pour l'opérateur et pour l'installation.

Certaines installations modulaires d'alimentation sans interruption de faible puissance disposent d'un système de connexion / déconnexion « à chaud », c'est-à-dire un système permettant de réaliser une connexion ou une déconnexion d'un module alors que l'installation est sous tension. Ce dispositif permet d'effectuer des opérations de maintenance ainsi que des opérations d'augmentation ou de réduction de puissance de l'installation sans interrompre l'alimentation de la charge. S'agissant d'installation de faible puissance les contraintes mécaniques et électriques sont différentes de celles à considérer dans le cadre des installations de forte puissance. Cette différence ne permet pas d'utiliser une technologie similaire.

Les systèmes connus de connexion / déconnexion pour les fortes puissances fonctionnent généralement « à froid », c'est-à-dire que l'installation doit être mise hors tension avant d'opérer une connexion ou une déconnexion. Ces systèmes fonctionnant « à froid » présentent par conséquent un MTTR élevé, c'est-à-dire qu'ils génèrent un temps important d'immobilisation de l'installation. En outre, il n'existe pas de connecteur compact disponible sur le marché permettant une déconnexion sous tension pour les fortes puissances, notamment pour des modules supérieurs à 100 kW.

Dans l'état de la technique, il est connu du document EP 1 022 757 un système de connexion électrique dont les tiroirs ne sont pas mobiles et nécessitant un outillage adapté pour établir la connexion et pour déplacer le tiroir dans ou hors du logement de l'installation.

Il est également connu des documents FR 2 744 347 et FR 2 990 620 des système mécaniques de levée, du document US 8 007 301 une pince de connexion de puissance similaire, et du document US 8 546 689 une connexion rapide d'une installation de forte puissance, utilisée dans le cas de maintenance de l'installation.

### Exposé de l'invention

L'invention a pour but de réduire le MTTR, c'est-à-dire le temps d'immobilisation de l'installation, à partir d'une installation d'alimentation sans interruption de forte puissance présentant des éléments modulaires comme des modules amovibles, ou tiroirs, et configurée pour réaliser une connexion électrique de puissance et de commande, en toute sécurité pour l'opérateur ainsi que pour l'installation, sans interrompre l'alimentation de la charge par l'installation.

Dans un objet de l'invention, il est proposé un système de connexion/déconnexion de puissance d'un module électrique de puissance dans une installation modulaire d'alimentation sans interruption de forte puissance, le système comprenant :
- une armature,
- un support rigide s'étendant selon une première direction,
- un jeu de connecteurs monté sur ledit support et comprenant un connecteur de terre destiné à être relié à la terre et des connecteurs de puissance destinés à alimenter le module et une charge, les connecteurs étant alignés successivement selon la première direction et conformés chacun pour être raccordées électriquement selon une seconde direction orthogonale à ladite première direction avec des barres de terre et de puissance d'un caisson de raccordement de puissance de l'installation et
- un dispositif de translation du support configuré pour déplacer à l'aide d'un actionneur le support dans ladite seconde direction.

Selon une caractéristique générale de l'invention, le connecteur de terre s'étend plus haut, autrement dit plus loin, selon la seconde direction que les connecteurs de puissance du jeu de connecteurs du module électrique de puissance, ledit connecteur de terre étant destiné à être électriquement raccordé à une barre de terre du caisson de raccordement de puissance.

Autrement dit, lorsque le jeu de connecteurs du système de connexion/déconnexion est distant des barres de puissance et de terre du caisson de raccordement, la distance selon la seconde direction séparant le connecteur de terre du module de la barre de terre du caisson de raccordement est toujours plus petite que la distance selon la seconde direction séparant les connecteurs de puissance du module des barres de puissance du caisson de raccordement.

L'installation d'alimentation sans interruption de forte puissance est réalisée sur le principe des faibles puissances, c'est-à-dire une installation de type « modulable ». La différence majeure est la dimension des modules, leur manipulation, ainsi que les contraintes électriques et électromagnétiques générées. La complexité principale réside dans le système de connexion électrique « à chaud » du module dans l'installation. Le système de connexion/déconnexion selon l'invention permet de réaliser cette connexion électrique de puissance et de commande, en toute sécurité pour l'opérateur ainsi que pour l'installation, sans interrompre l'alimentation de la charge.

En effet, l'invention permet de s'assurer que la terre est raccordée avant que toute autre connexion électrique ne soit établie, et d'être déconnectée après que toute autre connexion électrique a été déconnectée. Cela permet d'améliorer la sécurité de l'installation pour l'utilisateur.

Le module est autoportant, il est muni de quatre roulettes ce qui permet de le déplacer sans outils. Le module est muni dans sa partie supérieure du système de connexion « à chaud ».

Le dispositif de translation s'actionne par l'intermédiaire d'une manivelle ou bien d'un moteur. Le mouvement de rotation engendré par l'actionneur se transforme en mouvement de translation via une vis sans fin. Le mouvement de translation permet de faire monter le support sur lequel se trouvent le connecteur de terre et les connecteurs de puissance.

Selon un premier aspect du système de connexion/déconnexion de puissance, le jeu de connecteurs peut en outre comprendre un connecteur de commande s'étendant dans la seconde direction comme les connecteurs de puissance.

Selon un deuxième aspect du système de connexion/déconnexion de puissance, le dispositif de translation peut comporter en outre, une vis sans fin mécaniquement couplée à l'actionneur, au moins un ensemble formé d'un chariot mobile mécaniquement couplé à la vis sans fin et d'un croisillon comportant un premier et un second segments assemblés ensemble par un pion au centre de chaque segment, le premier segment comportant une première extrémité solidaire du chariot mobile et une seconde extrémité coopérant avec le support rigide, le second segment comportant une première extrémité fixe et solidaire de l'armature et une seconde extrémité coopérant avec le support rigide, et l'actionneur entraînant en rotation la vis sans fin autour de son axe, la rotation de la vis sans fin générant une translation du chariot mobile selon la première direction vers, ou à l'opposé de, la première extrémité du second segment, ce qui a pour conséquence de déployer, ou plier, le croisillon et ainsi de déplacer le support rigide selon la seconde direction. Dans un autre objet de l'invention, il est proposé un module électrique de puissance amovible destiné à être raccordé à une installation modulaire d'alimentation sans interruption de forte puissance comportant des barres de puissance et une barre de terre, le module électrique de puissance comportant des organes électriques de puissance aptes à alimenter une charge électrique via les barres de puissance de l'installation.

Selon une caractéristique générale de l'invention, l'installation comprend un système de connexion/déconnexion de puissance d'un module électrique de puissance telle que définie ci-dessus.

Selon un premier aspect du module électrique de puissance amovible, le module peut comprendre en outre une trappe d'accès audit système de connexion/déconnexion de puissance et un capteur de détection de l'ouverture et de la fermeture de ladite trappe d'accès.

Selon un second aspect du module électrique de puissance amovible, le module peut également comprendre un capteur de butée haute configuré pour détecter le positionnement du système de connexion/déconnexion dans une position dans laquelle tous les connecteurs du système de connexion/déconnexion sont raccordés aux éléments correspondants du caisson de raccordement de l'installation.

Dans un autre objet de l'invention, il est proposé une installation modulaire d'alimentation sans interruption de forte puissance comprenant une structure définissant des logements d'accueil de modules électriques amovibles, chaque logement étant doté de moyens de guidage d'un module électrique amovible et d'un caisson de raccordement de puissance.

Selon une caractéristique générale de l'invention, l'installation comprend au moins un module électrique de puissance amovible telle que définie ci-dessus.

Selon un premier aspect de l'installation modulaire d'alimentation sans interruption de forte puissance, le module électrique de puissance peut comprendre des roulettes montées sur le module pour coopérer avec les moyens de guidage d'un logement de l'installation.

Dans un autre objet de l'invention, il est proposé un procédé de connexion électrique d'un module électrique de puissance dans une installation modulaire d'alimentation sans interruption de forte puissance telle définie ci-dessus, l'installation étant sous tension.

Selon une caractéristique générale de l'invention, le procédé comprend un actionnement d'un dispositif de translation d'un jeu de connecteurs entraînant successivement, pendant l'actionnement, une connexion d'un connecteur de terre du module à une barre de terre du caisson de raccordement, puis une connexion de connecteurs de puissance du module aux barre de puissance du caisson de raccordement.

Selon un premier aspect du procédé de connexion électrique d'un module électrique de puissance, le procédé peut comprendre en outre, lors dudit actionnement du dispositif de translation, une connexion d'un connecteur de commande du module à une borne de commande du caisson de raccordement, à la suite de la connexion des connecteurs de puissance du module aux barres de puissance du caisson de raccordement.

Selon un deuxième aspect du procédé de connexion électrique d'un module électrique de puissance, le procédé peut comprendre en outre une détection de fin de course du dispositif de translation, puis une émission par l'installation d'un identifiant unique à l'unité de commande du module électrique.

Selon un troisième aspect du procédé de connexion électrique d'un module électrique de puissance, l'actionneur peut être commandé manuellement par un utilisateur, et le procédé peut comprendre en outre une détection de l'ouverture d'une trappe d'accès au système de connexion/déconnexion, l'installation délivrant à l'unité de commande du module électrique via le connecteur de commande un signal interdisant le démarrage des organes de puissance du module électrique tant que la trappe d'accès au système de connexion déconnexion est ouverte.

Selon un quatrième aspect du procédé de connexion électrique d'un module électrique de puissance, le procédé peut comprendre en outre, à la suite de la détection de fin de course du dispositif de translation, une détection de la fermeture de la trappe d'accès au système de connexion/déconnexion, puis une commande d'un cycle de test du module électrique avant d'autoriser un démarrage de l'alimentation du module électrique, le cycle de test comportant un vérification de la valeur de la tension d'entrée, une vérification des connexions des capteurs, une vérification de la qualité de la communication avec les autres modules électriques de l'installation.

Selon un cinquième aspect du procédé de connexion électrique d'un module électrique de puissance, le procédé peut comprendre en outre une commande de la fermeture d'un contacteur pour démarrer les organes de puissance et une commande de raccordement des organes de puissance aux connecteurs de puissance en fonction du résultat du cycle de test.

Dans un autre objet de l'invention, il est proposé un procédé de déconnexion électrique d'un module électrique de puissance dans une installation modulaire d'alimentation sans interruption de forte puissance tel que définie ci-dessus, l'installation étant sous tension.

Selon une caractéristique générale de l'invention, le procédé comprend un actionnement d'un dispositif de translation de connecteurs entraînant successivement, pendant l'actionnement, une déconnexion de connecteurs de puissance de l'installation aux barre de puissance du module électrique, puis une déconnexion d'un connecteur de terre de l'installation à une barre de terre du caisson de raccordement.

Selon un premier aspect du procédé de déconnexion électrique d'un module électrique de puissance, le procédé peut comprendre en outre, avant l'actionnement du dispositif de translation, une détection d'une ouverture de la trappe d'accès au système de connexion/déconnexion suivie une commande de l'arrêt des organes de puissance et une commande de déconnexion des organes de puissance des connecteurs de puissance du module électrique par l'ouverture d'un contacteur.

### Brève description des dessins

L'invention sera mieux comprise à la lecture faite ci-après, à titre indicatif mais non limitatif, en référence aux dessins annexés sur lesquels :
[Fig. 1] La figure 1 représente une vue schématique en perspective d'une installation modulaire d'alimentation sans interruption de forte puissance selon un mode de réalisation de l'invention.
[Fig. 2] La figure 2 illustre un logement et un module électrique de puissance de l'installation modulaire de la figure 1.
[Fig. 3] La figure 3 illustre un module électrique de puissance inséré dans un logement de l'installation de la figure 1.
[Fig. 4] La figure 4 présente schématiquement une vue en perspective du système de connexion/déconnexion électrique de puissance de l'installation de la figure 1.
[Fig. 5] La figure 5 représente une vue en perspective du dispositif de translation du support du système de connexion/déconnexion de la figure 2.
[Fig. 6] La figure 6 présente une vue du système de connexion/déconnexion et du module électrique de puissance de l'installation de la figure 1 à une position de déconnexion électrique.
[Fig. 7] La figure 7 présente une vue du système de connexion/déconnexion et du module électrique de puissance de l'installation de la figure 1 à une position à mi-parcours où seule la terre est connectée.
[Fig. 8] La figure 8 présente une vue du système de connexion/déconnexion et du module électrique de puissance de l'installation de la figure 1 à une position de connexion électrique.
[Fig. 9] La figure 9 présente un logigramme d'un procédé de connexion électrique d'un module électrique de puissance dans une installation modulaire d'alimentation sans interruption de forte puissance sous tension.
[Fig. 10] La figure 10 présente un logigramme d'un procédé de déconnexion électrique d'un module électrique de puissance dans une installation modulaire d'alimentation sans interruption de forte puissance sous tension.

### Description des modes de réalisation

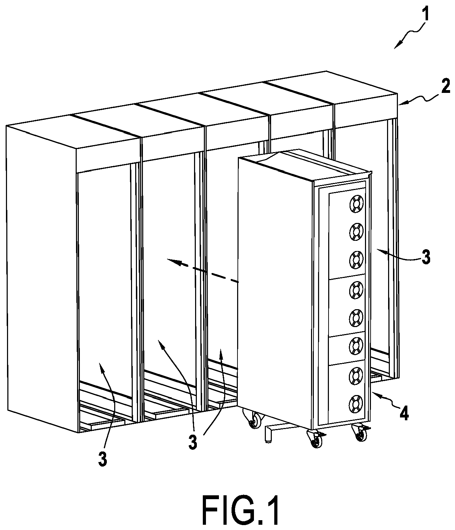

Sur la figure 1 est illustrée une installation modulaire d'alimentation sans interruption de forte puissance selon un mode de réalisation de l'invention.

L'installation modulaire d'alimentation sans interruption 1 comprend un bâti 2 définissant une pluralité de logements 3 configurés pour recevoir des modules électriques de puissance 4 amovibles.

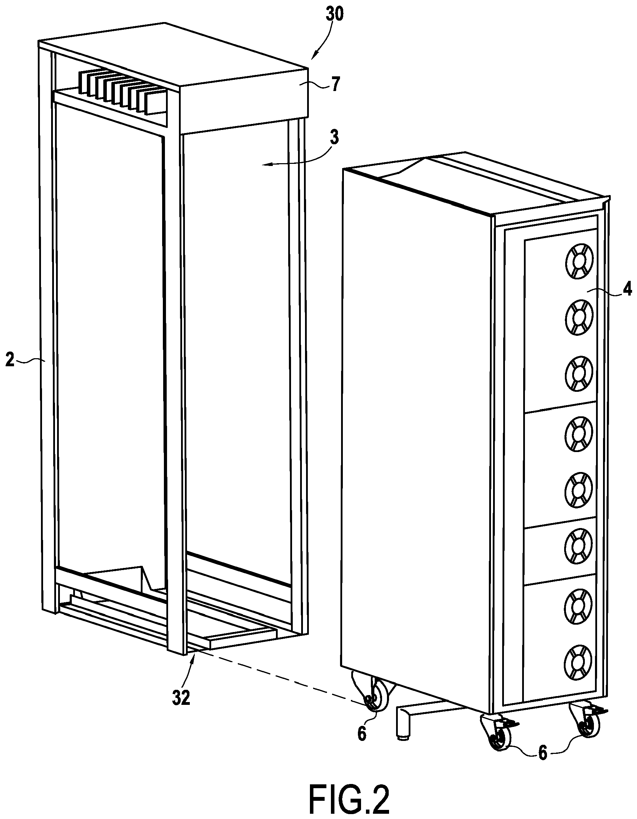

Sur la figure 2 est illustré une partie de l'installation 1 de la figure 1 illustrant notamment un logement 3 ainsi qu'un module électrique de puissance 4 comportant des organes électriques de puissance.

Le module 4 comprend un châssis 5 monté sur des roues 6 permettant de déplacer le module 4 et notamment de l'insérer dans le logement 3 ou de l'en extraire plus facilement.

Pour chaque logement d'accueil 3, le bâti 2 comprend des montants 20 s'étendant selon la hauteur du bâti 2 et des traverses 22 s'étendant dans un plan orthogonal aux montants 20. La hauteur du bâti 2 s'étend dans une direction orthogonale à un plan sur lequel les roues 6 du module 4 sont destinées à reposer. Chaque logement 3 présente une extrémité supérieure 30 et une extrémité inférieure 32 destinée à être en contact avec le sol sur lequel le bâti 2 repose. Le bâti 2 comprend, pour chaque logement 3, un caisson de raccordement électrique 7 disposé à l'extrémité supérieure 30 du logement 3. Chaque module 4 est destiné à être inséré dans un espace défini entre les montants 20 d'un logement 3 et entre l'extrémité inférieure 32 et le caisson de raccordement 7 du logement 3.

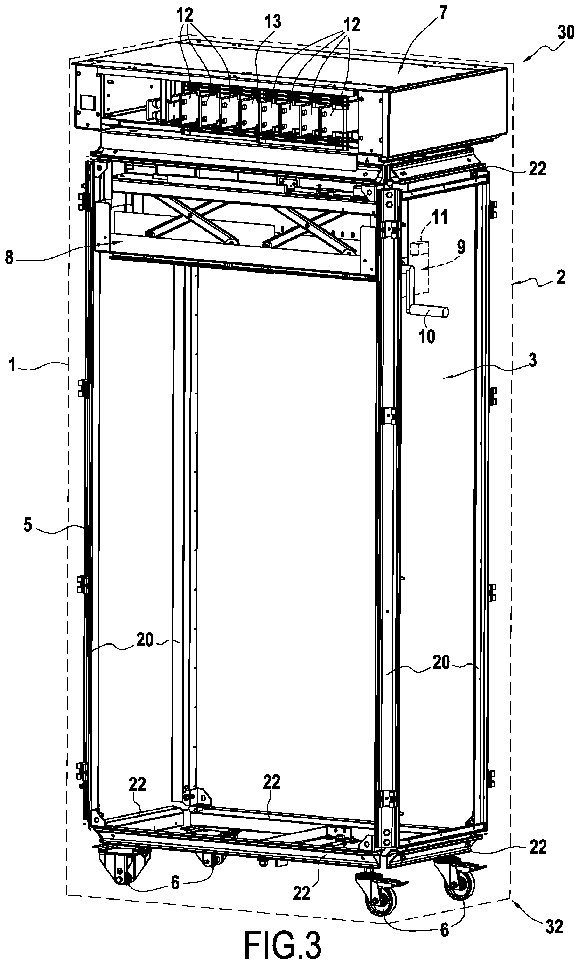

Comme cela est illustré sur la figure 3 qui illustre un module électrique de puissance 4 inséré dans un logement 3 de l'installation 1, chaque module 4 est équipé d'un système de connexion/déconnexion électrique de puissance 8 configuré pour électriquement connecter ou déconnecter le module 4 au caisson de raccordement 7 du logement 3 de l'installation 1 dans lequel il est inséré.

Chaque module 4 de l'installation 1 comprend une trappe 9 d'accès au système de connexion/déconnexion électrique de puissance permettant d'introduire une manivelle 10 dans un orifice formé dans le système de connexion/déconnexion et conformé pour coopérer avec la manivelle 10. Le module 4 de l'installation 1 comprend en outre un capteur 11 de détection de l'ouverture et de la fermeture de la trappe d'accès 9.

Le caisson 7 de raccordement électrique de puissance comporte des barres de puissance 12 destinées à être raccordées aux organes électriques de puissance du module électrique de puissance 4, et une barre de la terre 13 destinée à raccorder la terre du module électrique de puissance 4 à la terre.

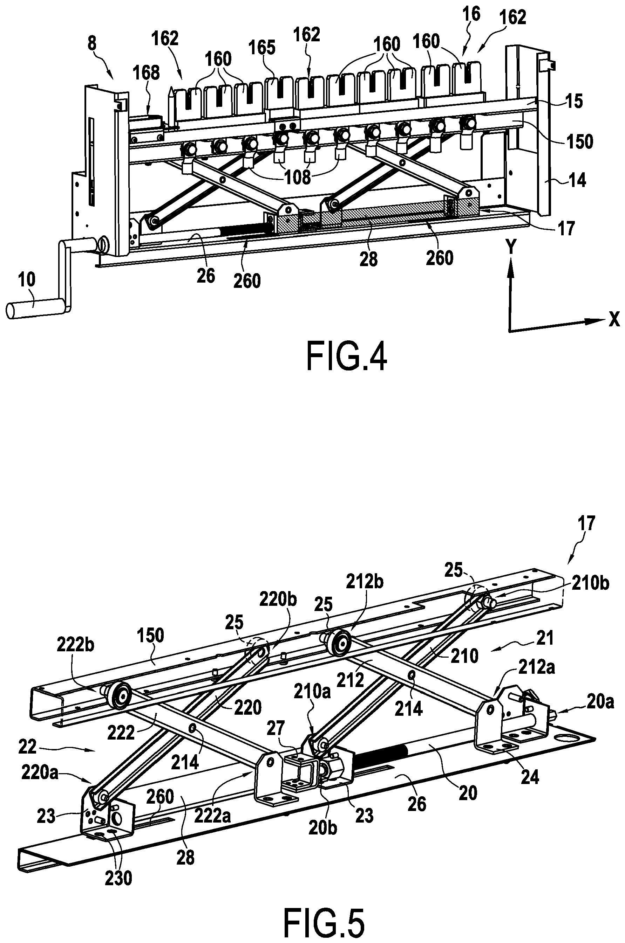

Sur la figure 4 est représentée schématiquement une vue en perspective du système de connexion/déconnexion 8 électrique de puissance de l'installation 1 de la figure 1.

Le système de connexion/déconnexion 8 comprend une armature 14, un support rigide 15, un jeu de connecteurs 16 et un dispositif de translation 17 du support rigide 15.

Le jeu de connecteurs 16 est disposé sur une portion supérieure du module 4 pour être positionné en regard du caisson de raccordement 7 lorsque le module est inséré dans un logement 3. Le jeu de connecteurs 16 comprend des connecteurs de puissance 160 destinés à être raccordés aux barres de puissance 12 du caisson de raccordement 7 pour alimenter le module 4 et la charge, un connecteur de terre 165 destiné à être raccordé à la barre de terre 13, et un connecteur de commande 168.

Le support rigide 15 s'étend selon une première direction X et les connecteurs 160 et 165 du jeu de connecteurs 16 sont montés selon cette première direction X sur le support 15. Chaque connecteur 160 et 165 comprend une fente 162 destinée à recevoir une barre de raccordement électrique 12 ou 13 du caisson 7 de raccordement électrique de puissance pour réaliser les différentes connexions électriques. Chaque connecteur 160 et 165 forme ainsi une pince de connexion électrique qui est reliée à une cosse 108 destinée à recevoir un câble électrique.

Sur la figure 5 est présentée une vue en perspective du dispositif de translation 17 du support 15 du système de connexion/déconnexion 7 de la figure 4.

Le dispositif de translation 17 est configuré pour déplacer le support 15 dans une seconde direction Y qui est orthogonale à la première direction X et parallèle à la direction selon laquelle les connecteurs de terre et de puissance 165 et 160 sont assemblés avec la barre de terre 13 et les barres de puissance 12 pour réaliser les différentes connexions électriques.

Le dispositif de translation 17 comprend la manivelle 10, une vis sans fin 20, un premier croisillon 21 et un second croisillon 22, et un premier et un second chariots mobiles 23.

La vis sans fin 20 comprend une première extrémité 20a et une seconde extrémité 20b. La première extrémité 20a de la vis sans fin 20 est mécaniquement couplée à la manivelle 10. La manivelle 10 comprend une extrémité qui s'insère dans un orifice de l'armature 14 du système de connexion/déconnexion 8 pour s'emboîter sur la première extrémité 20a de la vis sans fin 20. La première extrémité 20a de la vis sans fin 20 présente, sur l'exemple illustré sur la figure 5, une section hexagonale destinée à coopérer avec l'extrémité de la manivelle 10 qui présente une section cylindrique creuse à base hexagonale ce qui permet à la manivelle d'entraîner en rotation la vis sans fin 20.

Le premier croisillon 21 comporte un premier segment 210 et un second segment 212 assemblés ensemble par un pion 214 au centre de chaque segment 210 et 212. Le premier segment 210 du premier croisillon 21 comporte une première extrémité 210a solidaire du premier chariot mobile 23 et une seconde extrémité 210b coopérant avec le support rigide 15. Le second segment 212 du premier croisillon 21 comporte une première extrémité 212a fixée à l'armature 14 à l'aide d'une cornière de liaison 24 et une seconde extrémité 212b coopérant avec le support rigide 15. La seconde extrémité 210b du premier segment 210 et la seconde extrémité 212b du second segment 212 du premier croisillon 21 comprennent chacun une roulette 25 destinée à se déplacer dans une glissière d'un profilé 150 du support rigide 15.

Le profilé 150 du support rigide a une section, dans un plan de coupe orthogonal à la première direction X, rectangulaire ouverte partiellement sur un côté, le côté en regard de la vis sans fin 20, formant ainsi deux glissières, ou rails, en regard l'une de l'autre. Chaque segment 210 et 212 du premier croisillon 21 présente une première face et une seconde face opposée à la première face. La première face du premier segment 210 est orientée vers le second segment 212 et la première face du second segment 212 est orientée vers le premier segment 210. Les roulettes 25 du premier croisillon 21 sont fixées sur la seconde face des premier et second segments 210 et 212.

Le premier croisillon 21 s'insère dans le profilé 150 du support 15 au travers de l'ouverture du profilé 150, et chacune des deux roulettes 25 se déplace dans une des deux glissières du profilé 150.

Le second croisillon 22 comporte un premier segment 220 et un second segment 222 assemblés ensemble par un pion 214 au centre de chaque segment 220 et 222. Le premier segment 220 du second croisillon 22 comporte une première extrémité 220a solidaire du second chariot mobile 23 et une seconde extrémité 220b coopérant avec le support rigide 15. Le second segment 222 du second croisillon 22 comporte une première extrémité 222a fixée à l'armature 14 à l'aide d'une cornière de liaison 24 et une seconde extrémité 222b coopérant avec le support rigide 15. La seconde extrémité 220b du premier segment 220 et la seconde extrémité 222b du second segment 222 du second croisillon 22 comprennent chacun une roulette 25 destinée à se déplacer dans une glissière d'un profilé 150 du support rigide 15.

Chaque segment 220 et 222 du second croisillon 22 présente une première face et une seconde face opposée à la première face. La première face du premier segment 220 est orientée vers le second segment 222 et la première face du second segment 222 est orientée vers le premier segment 220. Les roulettes 25 du second croisillon 21 sont fixées sur la seconde face des premier et second segments 220 et 222.

Le second croisillon 22 s'insère dans le profilé 150 du support 15 au travers de l'ouverture du profilé 150, et chacune des deux roulettes 25 se déplace dans une des deux glissières du profilé 150.

Le dispositif de translation 17 du support 15 comprend une plaque 26 sur laquelle sont fixées les cornières de liaison 24 des deux croisillons 21 et 22. Cette plaque 26 comprend deux fentes de guidages 260 coopérant chacune avec un des premier et second chariot mobile 23 pour permettre une translation des chariots mobiles 23 le long de la première direction X, les chariots mobiles 23 comprenant chacun un pion de guidage 230 coulissant à l'intérieure de la fente de guidage 260.

Le dispositif de translation comprend en outre une plaque de solidarisation 28 sur laquelle sont fixées les chariots mobiles 23 de sorte que le déplacement d'un chariot mobile 23, notamment le chariot mobile coopérant avec la vis sans fin 20, entraîne le déplacement de l'autre chariot mobile 23, ce qui permet ainsi que les deux croisillons 21 et 22 soient animés d'un même mouvement de translation simultanément. La plaque de solidarisation 28 s'étend dans un plan parallèle au plan dans lequel s'étend la plaque 26 sur laquelle sont fixées les cornières de liaison 24, mais sans contact avoir de contact avec ladite plaque 26.

Le dispositif de translation 17 du support 15 comprend en outre une butée 27 fixée sur la plaque 26 et disposée entre les deux croisillons 21 et 22. La seconde extrémité 20b de la vis sans fin 20 est fixée à la butée 27 de manière libre en rotation de manière à pouvoir tourner autour de son axe X' sans se déplacer dans la première ou la seconde directions X, Y. Le premier chariot mobile 23 du premier croisillon 21 vient en appui contre la butée 27 en fin de course.

La manivelle 10 entraîne en rotation la vis sans fin 20 autour de son axe X'. La rotation de la vis sans fin 20 génère une translation du premier chariot mobile 23 selon la première direction X vers, ou à l'opposé de, la première extrémité 212a du second segment 212 du premier croisillon, ce qui a pour conséquence de déployer, ou plier, le croisillon 21 et ainsi de déplacer le support rigide 15 selon la seconde direction Y.

La plaque de solidarisation28 fixée sur les deux chariots mobiles 23 permet le déplacement simultané des deux chariots 23 et donc l'élévation, ou l'abaissement du support rigide 15 par les croisillons 21 et 22.

Comme illustré sur la figure 3, le connecteur de terre 165 s'étend plus haut selon la seconde direction Y que les connecteurs de puissance 160 du jeu de connecteurs 16, pour que la terre soit toujours connectée avant les connecteurs de puissance 160 et déconnectée après les connecteurs de puissance 160.

Chaque module 4 comprend également un capteur de butée haute pour détecter l'arrivée en fin de course du système de connexion/déconnexion 8.

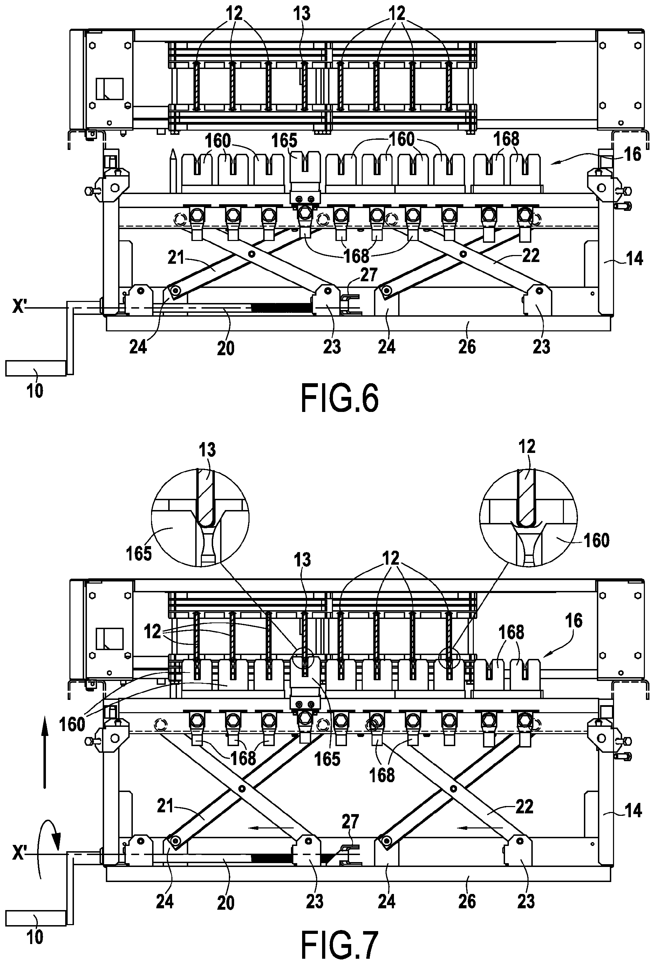

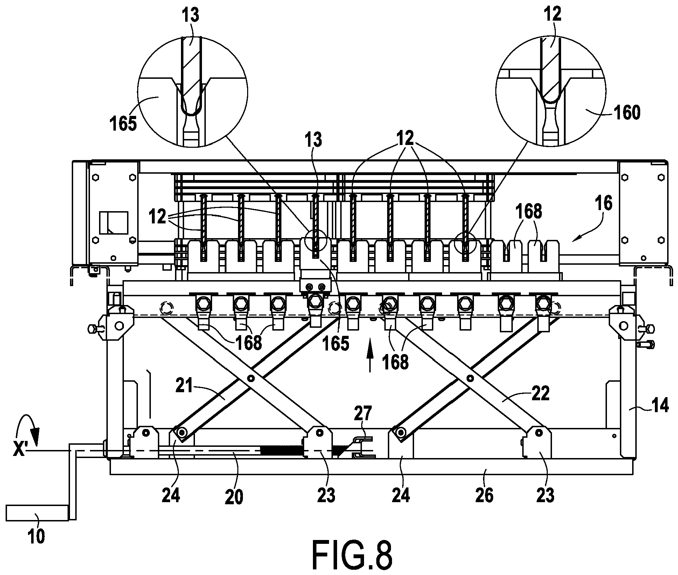

Sur les figures 6 à 8 sont représentées trois vues du système de connexion/déconnexion 8 et du caisson 7 de raccordement électrique de puissance de l'installation 1 de la figure 3 respectivement à une position de déconnexion électrique (figure 6), une position à mi-parcours où seule la terre est connectée (figure 7) et une position de connexion électrique (figure 8).

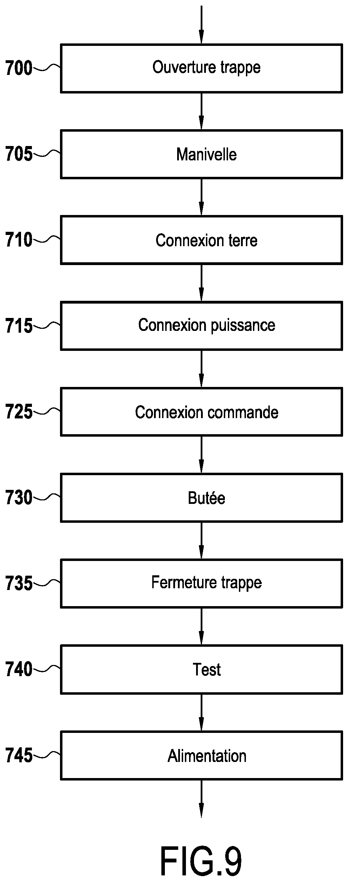

Et sur la figure 9 est présenté un logigramme d'un procédé de connexion électrique d'un module électrique de puissance 4 dans un logement d'accueil 3 modulaire sous tension d'une installation modulaire 1 d'alimentation sans interruption de forte puissance.

A la suite d'une insertion d'un module de puissance 4 amovible dans un logement d'accueil 3 de l'installation 1, dans une première étape 700 du procédé, on ouvre la trappe 9 d'accès au système de connexion/déconnexion 8 et l'ouverture de la trappe 9 est détectée par le capteur dédié 11 qui délivre en continu un signal interdisant le démarrage des organes de puissance du module 4 tant que la trappe 9 d'accès à l'actionneur est ouverte. Le signal sera délivré à une unité électronique de commande du module 4 lorsque le connecteur de commande 168 sera connecté à une borne de commande du du caisson de raccordement 7 du logement 3.

Dans une étape suivante 705, on connecte la manivelle 10 à la première extrémité 20a de la vis sans fin 20, et on actionne le dispositif de translation 17 en tournant la manivelle 10. Comme cela est illustré sur la figure 5, la rotation de la vis sans fin 20 via la manivelle 10 entraîne le déplacement du premier chariot mobile 23 et du second chariot mobile 23 via la plaque de solidarisation 28 dans la première direction X respectivement vers la cornière de liaison 24 du premier croisillon 21 et respectivement vers la cornière de liaison 24 du second croisillon 22 ce qui déploie les croisillons 21 et 22 et déplace ainsi le support rigide 15 dans la seconde direction Y.

L'élévation du support rigide 15 vers le caisson 7 de raccordement de puissance va entraîner, dans une étape 710, le raccordement tout d'abord du connecteur de terre 165 à la barre de terre 13 comme cela est illustré sur la figure 7. Dans cette position, seul la terre est reliée, les connecteurs de puissance 160 étant encore distants des barres de puissances 12.

En continuant de tourner la manivelle 10, le dispositif de translation 17 continue le déploiement des croisillons 21 et 22 ce qui permet, dans une étape suivante 715, de connecter simultanément tous les connecteurs de puissance 160 aux barres de puissance 12 du caisson 7 de raccordement comme illustré sur la figure 8.

Dans une étape suivante 725, en continuant de tourner la manivelle 10, le dispositif de translation 17 continue le déploiement des croisillons 21 et 22 ce qui permet de connecter le connecteur de commande 168 au connecteur de commande du caisson de raccordement 7 du logement 3 non représentées sur les figures 4 et 6.

Dans une étape suivante 730, le support rigide 15 vient en butée en position haute et on détecte une fin de course du dispositif de translation 17 à l'aide d'un capteur de fin de course qui émet un identifiant unique de l'installation 1 à l'unité électronique de commande du module électrique de puissance 4.

Dans une étape suivante 735, la manivelle 10 est retirée et la trappe 9 d'accès au système de connexion/déconnexion 8 est refermée. Le capteur 11 de détection de l'ouverture et de la fermeture de la trappe d'accès 9 délivre alors à l'unité électronique de commande un signal de fermeture de la trappe d'accès 9.

Dans une étape suivante 740, on lance un cycle de test du module électrique 4. La phase de test comprend une identification de la carte sur le bus de communication, une vérification des versions du logiciel, une vérification des paramètres, une vérification des tensions, une vérification des contacts de fin de course, un démarrage de la pré-charge des condensateurs chimiques, un démarrage de l'onduleur en double conversion, et une fermeture du contacteur alimentant la charge.

Dans une étape suivante 745, la charge est alimentée par le module 4 au travers des barres de puissances 12 du caisson de raccordement 7 du logement 3 de l'installation 1.

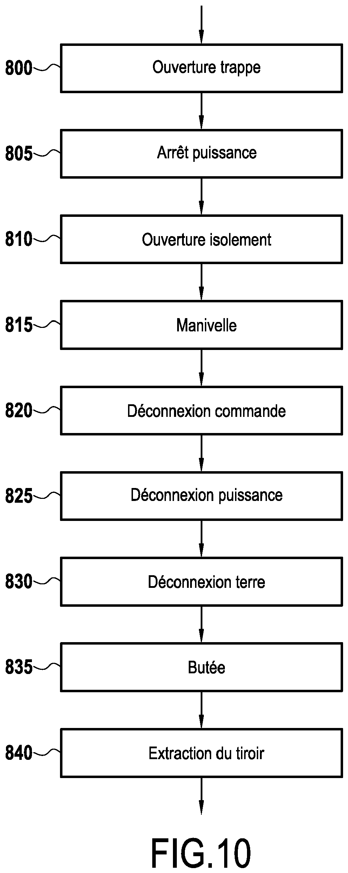

Sur la figure 10 est présenté un logigramme d'un procédé de déconnexion électrique d'un module électrique de puissance 4 dans une installation 1 modulaire d'alimentation sans interruption de forte puissance sous tension.

Dans une première étape 800 du procédé de déconnexion, on ouvre la trappe d'accès 9 et on détecte l'ouverture de la trappe d'accès 9 à l'aide du capteur 11 dédié.

Dans deuxième étape 805 du procédé de déconnexion, on commande un arrêt des organes de puissance du module électrique 4.

Dans une troisième étape 810, on commande l'ouverture de l'organe d'isolement de sortie et de l'organe d'isolement d'entrée du module électrique 4.

Dans une quatrième étape 815, on actionne le système de connexion/déconnexion 8 à l'aide de la manivelle 10, ce qui permet, dans une cinquième étape 820, de découpler électriquement le connecteur de commande 168 du module 4 de la borne de commande du caisson de raccordement 7 du logement 3, puis, dans une sixième étape 825, de déconnecter les connecteurs de puissance 160 des barres de puissance 12, puis, dans une septième étape 830, à la suite de la sixième étape 825, de découpler le connecteur de terre 165 de la barre de terre 13.

Dans une huitième étape 835, le dispositif de translation 17 arrive en butée basse de l'armature 14 du système de connexion/déconnexion 8, puis on extrait, dans une neuvième étape 840, le module électrique de puissance 4 amovible de l'installation 1.

L'invention permet d'annuler le temps d'immobilisation d'une installation d'alimentation sans interruption de forte puissance présentant des éléments modulaires comme des modules amovibles, c'est-à-dire une installation comprenant des « modules », et configurée pour réaliser une connexion électrique de puissance et de commande, en toute sécurité pour l'opérateur ainsi que pour l'installation, sans interrompre l'alimentation de la charge par l'installation.

## Revendications

1. Système de connexion/déconnexion de puissance (8) d'un module électrique de puissance (4) dans une installation (1) modulaire d'alimentation sans interruption de forte puissance, le système (8) comprenant :
- une armature (14),
- un support rigide (15) s'étendant selon une première direction (X),
- un jeu de connecteurs (16) monté sur ledit support (15) et comprenant un connecteur de terre (165) relié à la terre et des connecteurs de puissance (160) destinés à alimenter le module (4) et une charge, les connecteurs (165, 160) étant alignés successivement selon la première direction (X) et conformés chacun pour être raccordées électriquement selon une seconde direction (Y) orthogonale à ladite première direction (X) avec des barres de terre et de puissance (13, 12) d'un caisson de raccordement de puissance (7) de l'installation (1), et
- un dispositif de translation (17) du support (15) configuré pour déplacer à l'aide d'un actionneur (10) le support (15) dans ladite seconde direction (Y), **caractérisé en ce que** le connecteur de terre (165) s'étend plus haut selon la seconde direction (Y) que les connecteurs de puissance (160) du jeu de connecteurs (16) du module électrique de puissance (4), ledit connecteur de terre (165) étant destiné à être électriquement raccordé à une barre de terre (13) du caisson de raccordement de puissance (7).

2. Système (8) selon la revendication 1, dans lequel le jeu de connecteurs (16) comprend en outre un connecteur de commande (168) s'étendant dans la seconde direction (Y) comme les connecteurs de puissance (160).

3. Système (8) selon l'une des revendications 1 ou 2, dans lequel le dispositif de translation (17) comporte en outre, une vis sans fin (20) mécaniquement couplée à l'actionneur (10), un ensemble formé d'un chariot mobile (23) mécaniquement couplé à la vis sans fin (20) et d'un croisillon (21) comportant un premier et un second segments (210, 212) assemblés ensemble par un pion (214) au centre de chaque segment (210, 212), le premier segment (210) comportant une première extrémité (210a) solidaire du chariot mobile (23) et une seconde extrémité (210b) coopérant avec le support rigide (15), le second segment (212) comportant une première extrémité (212a) fixe et solidaire de l'armature (14) et une seconde extrémité (212b) coopérant avec le support rigide (15), et l'actionneur (10) entraînant en rotation la vis sans fin (20) autour de son axe (X'), la rotation de la vis sans fin (20) générant une translation du chariot mobile (23) selon la première direction (X) vers, ou à l'opposé de, la première extrémité (212a) du second segment (212), ce qui a pour conséquence de déployer, ou plier, le croisillon (21) et ainsi de déplacer le support rigide (15) selon la seconde direction (Y).

4. Module électrique de puissance amovible (4) destiné à être raccordé à une installation (1) modulaire d'alimentation sans interruption de forte puissance comportant des barres de puissance (12) et une barre de terre (13), le module électrique de puissance (4) comportant des organes électriques de puissance aptes à alimenter une charge électrique via les barres de puissance (12) de l'installation (1),
**caractérisé en ce qu'**il comprend un système de connexion électrique (8) de puissance d'un module électrique de puissance (4) selon l'une des revendications 1 à 3.

5. Module électrique de puissance amovible (4) selon la revendication 4, comprenant en outre une trappe (9) d'accès audit système de connexion/déconnexion de puissance (8) et un capteur (11) de détection de l'ouverture et de la fermeture de ladite trappe d'accès (9).

6. Module électrique de puissance amovible (4) selon l'une des revendications 4 ou 5, comprenant en outre un capteur de butée haute configuré pour détecter le positionnement du système de connexion/déconnexion (8) dans une position dans laquelle tous les connecteurs (160, 165, 168) du système de connexion/déconnexion (8) sont raccordés aux éléments correspondants du caisson de raccordement (7) de l'installation (1).

7. Installation (1) modulaire d'alimentation sans interruption de forte puissance comprenant une structure définissant des logements d'accueil (3) de modules électriques amovibles (4), chaque logement (3) étant doté de moyens de guidage d'un module électrique amovible (4) et d'un caisson de raccordement de puissance (7),
**caractérisé en ce qu'**elle comprend au moins un module électrique de puissance (4) amovible selon l'une des revendications 4 à 6.

8. Installation (1) selon la revendication 7, dans lequel le module électrique de puissance (4) comprend des roulettes (6) montées sur un bâti 5 du module (4) pour coopérer avec les moyens de guidage d'un logement d'accueil (3) de l'installation (1).

9. Procédé de connexion électrique d'un module électrique de puissance (4) dans une installation (1) modulaire d'alimentation sans interruption de forte puissance selon l'une des revendications 7 ou 8, l'installation (1) étant sous tension,
**caractérisé en ce qu'**il comprend un actionnement (705) d'un dispositif de translation (17) d'un jeu de connecteurs (16) entraînant successivement, pendant l'actionnement, une connexion (710) d'un connecteur de terre (165) du module (4) à une barre de terre (13) du caisson de raccordement (7), puis une connexion (715) de connecteurs de puissance (160) du module (4) aux barre de puissance (12) du caisson de raccordement (7).

10. Procédé de connexion électrique selon la revendication 9, comprenant en outre, lors dudit actionnement du dispositif de translation (17), une connexion (725) d'un connecteur de commande (168) du module (4) à une borne de commande, à la suite de la connexion (715) des connecteurs de puissance (160) du module (4) aux barre de puissance (12) du caisson de raccordement (7).

11. Procédé de connexion électrique selon l'une des revendications 9 ou 10, comprenant en outre une détection (730) de fin de course du dispositif de translation (17), puis une émission par l'installation d'un identifiant unique à l'unité de commande du module (4).

12. Procédé de connexion électrique selon l'une des revendications 9 à 11, dans lequel l'actionneur (10) est commandé manuellement par un utilisateur, et le procédé comprend en outre une détection (700) de l'ouverture d'une trappe d'accès (9) au système de connexion/déconnexion (8), l'installation (1) délivrant à l'unité de commande du module électrique (4) via le connecteur de commande (168) un signal interdisant le démarrage des organes de puissance du module électrique (4) tant que la trappe d'accès (9) au système de connexion/déconnexion est ouverte.

13. Procédé de connexion électrique selon les revendications 11 et 12 prises en combinaison, comprenant en outre, à la suite de la détection (730) de fin de course du dispositif de translation, une détection (735) de la fermeture de la trappe d'accès (9) au système de connexion/déconnexion, puis une commande (740) d'un cycle de test du module électrique (4) avant d'autoriser un démarrage de l'alimentation du module électrique (4), le cycle de test comportant un vérification de la valeur de la tension d'entrée, une vérification des connexions des capteurs, une vérification de la qualité de la communication avec les autres modules électriques (4) de l'installation (1).

14. Procédé de connexion électrique selon la revendication 13, comprenant en outre une commande (745) de démarrage des organes de puissance et une commande de la fermeture d'un contacteur pour raccorder les organes de puissance aux connecteurs de puissance (160) en fonction du résultat du cycle de test.

15. Procédé de déconnexion électrique d'un module électrique de puissance (4) dans une installation (1) modulaire d'alimentation sans interruption de forte puissance selon l'une des revendications 7 ou 8, l'installation (1) étant sous tension,
**caractérisé en ce qu'**il comprend un actionnement (815) d'un dispositif de translation (17) de connecteurs entraînant successivement, pendant l'actionnement, une déconnexion (825) des connecteurs de puissance (160) du module (4) des barres de puissance (12) du caisson de raccordement (7), puis une déconnexion (830) d'un connecteur de terre (165) de du module (4) d'une barre de terre (13) du caisson de raccordement (7).

16. Procédé de déconnexion électrique selon la revendication 15, comprenant en outre, avant l'actionnement du dispositif de translation (17), une détection (800) d'une ouverture de la trappe d'accès (9) au système de connexion/déconnexion (8) suivie d'une commande (805) de l'arrêt des organes de puissance et une commande de déconnexion des organes de puissance des connecteurs de puissance (160) du module électrique (4) par l'ouverture d'un contacteur.

## Patentansprüche

1. System zur Verbindung/Trennung des Stroms (8) eines elektrischen Leistungsmoduls (4) in einer modularen Versorgungsanlage (1) ohne Unterbrechung der Stromversorgung, wobei das System (8) umfasst:
- eine Armierung (14),
- eine starre Halterung (15), die sich gemäß einer ersten Richtung (X) erstreckt,
- einen Verbindersatz (16), der auf der Halterung (15) angebracht ist und eine Erdung (165) umfasst, die mit der Erde verbunden ist und Leistungsverbinder (160), die bestimmt sind, das Modul (4) zu versorgen und eine Last, wobei die Verbinder (165, 160) nacheinander gemäß der ersten Richtung (X) ausgerichtet und jeweils eingerichtet sind, um gemäß einer zweiten Richtung (Y) orthogonal zur ersten Richtung (X) mit Erdungs- und Stromschienen (13, 12) eines Stromanschlussgehäuses (7) der Anlage (1) elektrisch verbunden zu sein, und
- eine Translationsvorrichtung (17) der Halterung (15), die ausgelegt ist, um die Halterung (15) mit Hilfe eines Aktuators (10) in der zweiten Richtung (Y) zu verschieben, **dadurch gekennzeichnet, dass** sich die Erdung (165) gemäß der zweiten Richtung (Y) höher als die Leistungsverbinder (160) des Verbindersatzes (16) des elektrischen Leistungsmoduls (4) erstreckt, wobei die Erdung (165) bestimmt ist, mit einer Erdungsschiene (13) des Stromanschlussgehäuses (7) elektrisch verbunden zu sein.

2. System (8) nach Anspruch 1, wobei der Verbindersatz (16) ferner einen Steuerungsverbinder (168) umfasst, der sich in der zweiten Richtung (Y) wie die Leistungsverbinder (160) erstreckt.

3. System (8) nach einem der Ansprüche 1 oder 2, wobei die Translationsvorrichtung (17) ferner eine Schnecke (20) aufweist, die mit dem Aktuator (10) mechanisch gekoppelt ist, eine Anordnung, die aus einem beweglichen Schlitten (23), der mit der Schnecke (20) mechanisch gekoppelt ist, und einer Überkreuzung (21) gebildet ist, die ein erstes und ein zweites Segment (210, 212) aufweist, die mit einem Stift (214) im Zentrum jedes Segments (210, 212) zusammengefügt sind, wobei das erste Segment (210) ein erstes Ende (210a) aufweist, das mit dem beweglichen Schlitten (23) fest verbunden ist, und ein zweites Ende (210b), das mit der starren Halterung (15) zusammenwirkt, wobei das zweite Segment (212) ein erstes Ende (212a) aufweist, das fest ist und mit der Armierung (14) fest verbunden ist und ein zweites Ende (212b), das mit der starren Halterung (15) zusammenwirkt, und der Aktuator (10) die Schnecke (20) um ihre Achse (X') rotatorisch antreibt, wobei die Rotation der Schnecke (20) eine Translation des beweglichen Schlittens (23) gemäß der ersten Richtung (X) zur oder entgegengesetzt zum ersten Ende (212a) des zweiten Segments (212) erzeugt, was zur Folge hat, dass die Überkreuzung (21) ausgefahren oder zusammengefaltet und somit die starre Halterung (15) gemäß der zweiten Richtung (Y) verschoben wird.

4. Lösbares elektrisches Leistungsmodul (4), das bestimmt ist, mit einer modularen Versorgungsanlage (1) ohne Unterbrechung der Stromversorgung verbunden zu sein, aufweisend Stromschienen (12) und eine Erdungsschiene (13), wobei das elektrische Leistungsmodul (4) elektrische Leistungsorgane aufweist, die imstande sind, über die Stromschienen (12) der Anlage (1) eine elektrische Last zu versorgen,
**dadurch gekennzeichnet, dass** es ein System zur Verbindung (8) des Stroms eines elektrischen Leistungsmoduls (4) nach einem der Ansprüche 1 bis 3 umfasst.

5. Lösbares elektrisches Leistungsmodul (4) nach Anspruch 4, das ferner eine Zugangsklappe (9) zum System zur sicheren Verbindung/Trennung des Stroms (8) und einen Sensor (11) zur Ermittlung der Öffnung und der Schließung der Zugangsklappe (9) umfasst.

6. Lösbares elektrisches Leistungsmodul (4) nach einem der Ansprüche 4 oder 5, das ferner einen Sensor für den oberen Anschlag umfasst, der ausgelegt ist, um die Positionierung des Systems zur Verbindung/Trennung (8) in einer Position zu ermitteln, in der alle Verbinder (160, 165, 168) des Systems zur Verbindung/Trennung (8) mit entsprechenden Elementen des Anschlussgehäuses (7) der Anlage (1) verbunden sind.

7. Modulare Versorgungsanlage (1) ohne Unterbrechung der Stromversorgung, umfassend eine Struktur, die Empfangsaufnahmen (3) lösbarer elektrischer Module (4) definiert, wobei jede Aufnahme (3) mit Führungsmitteln eines lösbaren elektrischen Moduls (4) und eines Stromanschlussgehäuses (7) versehen ist,
**dadurch gekennzeichnet, dass** sie mindestens ein lösbares elektrisches Leistungsmodul (4) nach einem der Ansprüche 4 bis 6 umfasst.

8. Anlage (1) nach Anspruch 7, wobei das elektrische Leistungsmodul (4) Räder (6) umfasst, die an einem Gestell (5) des Moduls (4) befestigt sind, um mit den Führungsmitteln einer Empfangsaufnahme (3) der Anlage (1) zusammenzuwirken.

9. Verfahren zur elektrischen Verbindung eines elektrischen Leistungsmoduls (4) in einer modularen Versorgungsanlage (1) ohne Unterbrechung der Stromversorgung nach einem der Ansprüche 7 oder 8, wobei die Anlage (1) unter Spannung steht,
**dadurch gekennzeichnet, dass** es eine Betätigung (705) einer Translationsvorrichtung (17) eines Verbindersatzes (16) umfasst, die nacheinander während der Betätigung eine Verbindung (710) einer Erdung (165) des Moduls (4) mit einer Erdungsschiene (13) des Anschlussgehäuses (7), dann eine Verbindung (715) von Leistungsverbindern (160) des Moduls (4) mit den Stromschienen (12) des Anschlussgehäuses (7) bewirkt.

10. Verfahren zur elektrischen Verbindung nach Anspruch 9, das ferner bei der Betätigung der Translationsvorrichtung (17) eine Verbindung (725) eines Steuerungsverbinders (168) des Moduls (4) mit einer Steuerklemme infolge der Verbindung (715) des Leistungsverbinders (160) des Moduls (4) mit den Stromschienen (12) des Anschlussgehäuses (7) umfasst.

11. Verfahren zur elektrischen Verbindung nach einem der Ansprüche 9 oder 10, umfassend ferner eine Endlagenermittlung (730) der Translationsvorrichtung (17), dann eine Sendung einer einzigen Kennung an die Steuereinheit des Moduls (4) durch die Anlage.

12. Verfahren zur elektrischen Verbindung nach einem der Ansprüche 9 bis 11, wobei der Aktuator (10) von einem Benutzer manuell gesteuert wird und das Verfahren ferner eine Ermittlung (700) der Öffnung einer Zugangsklappe (9) zum System zur Verbindung/Trennung (8) umfasst, wobei die Anlage (1) der Steuereinheit des elektrischen Moduls (4) über den Steuerungsverbinder (168) ein Signal bereitstellt, das den Start der Leistungsorgane des elektrischen Moduls (4) untersagt, solange die Zugangsklappe (9) zum System zur Verbindung/Trennung geöffnet ist.

13. Verfahren zur elektrischen Verbindung nach den Ansprüchen 11 und 12 in Kombination, umfassend ferner nach der Endlagenermittlung (730) der Translationsvorrichtung eine Ermittlung (735) des Schließens der Zugangsklappe (9) zum System zur Verbindung/Trennung, dann eine Steuerung (740) eines Testzyklus des elektrischen Moduls (4) vor Genehmigung eines Starts der Versorgung des elektrischen Moduls (4), wobei der Testzyklus eine Überprüfung des Werts der Eingangsspannung, eine Überprüfung der Verbindungen der Sensoren, eine Überprüfung der Qualität der Kommunikation mit den anderen elektrischen Modulen (4) der Anlage (1) aufweist.

14. Verfahren zur elektrischen Verbindung nach Anspruch 13, umfassend ferner eine Steuerung (745) des Starts der Leistungsorgane und eine Steuerung des Schließens eines Verbinders, um die Leistungsorgane mit den Leistungsverbindern (160) in Abhängigkeit vom Ergebnis des Testzyklus zu verbinden.

15. Verfahren zum elektrischen Trennen eines elektrischen Leistungsmoduls (4) in einer modularen Versorgungsanlage (1) ohne Unterbrechung der Stromversorgung nach einem der Ansprüche 7 oder 8, wobei die Anlage (1) unter Spannung ist,
**dadurch gekennzeichnet, dass** es eine Betätigung (815) einer Translationsvorrichtung (17) von Verbindern umfasst, die nacheinander während der Betätigung eine Trennung (825) der Leistungsverbinder (160) des Moduls (4) von den Stromschienen (12) des Anschlussgehäuses (7), dann eine Trennung (830) einer Erdung (165) des Moduls (4) von einer Erdungsschiene (13) des Anschlussgehäuses (7) bewirkt.

16. Verfahren zum elektrischen Trennen nach Anspruch 15, umfassend ferner vor der Betätigung der Translationsvorrichtung (17) eine Ermittlung (800) einer Öffnung der Zugangsklappe (9) zum System zur Verbindung/Trennung (8), gefolgt von einer Steuerung (805) des Stopps der Leistungsorgane und eine Steuerung der Trennung der Leistungsorgane von den Leistungsverbindern (160) des elektrischen Moduls (4) durch die Öffnung eines Verbinders.

## Claims

1. A power connection/disconnection system (8) for connecting/disconnecting an electric power module (4) in a high-power modular uninterruptable power supply installation (1), the system (8) comprising:
- a frame (14),
- a rigid support (15) extending along a first direction (X),
- a set of connectors (16) mounted on said support (15) and comprising a ground connector (165) connected to the ground and power connectors (160) intended to supply the module (4) and a load, the connectors (165, 160) being successively aligned along the first direction (X) and each shaped to be electrically connected along a second direction (Y) orthogonal to said first direction (X) with ground and power bars (13, 12) of a power connection box (7) of the installation (1), and
- a device for translating (17) the support (15) configured to move, using an actuator (10), the support (15) in said second direction (Y),
**characterized in that** the ground connector (165) extends higher along the second direction (Y) than the power connectors (160) of the set of connectors (16) of the electric power module (4), said ground connector (165) being intended to be electrically connected to a ground bar (13) of the power connection box (7).

2. The system (8) according to claim 1, wherein the set of connectors (16) further comprises a control connector (168) extending in the second direction (Y) like the power connectors (160).

3. The system (8) according to any of claims 1 or 2, wherein the translation device (17) further includes a worm screw (20) mechanically coupled to the actuator (10), an assembly formed of a movable carriage (23) mechanically coupled to the worm screw (20) and of a bracing (21) including a first and a second segment (210, 212) assembled together by a pin (214) at the center of each segment (210, 212), the first segment (210) including a first end (210a) secured to the movable carriage (23) and a second end (210b) cooperating with the rigid support (15), the second segment (212) including a first end (212a) fixed and secured to the frame (14) and a second end (212b) cooperating with the rigid support (15), and the actuator (10) driving in rotation the worm screw (20) about its axis (X'), the rotation of the worm screw (20) generating a translation of the movable carriage (23) along the first direction (X) towards, or away from, the first end (212a) of the second segment (212), which has the consequence of deploying or folding the bracing (21) and thus moving the rigid support (15) along the second direction (Y).

4. A removable electric power module (4) intended to be connected to a high-power modular uninterruptable power supply installation (1) including power bars (12) and a ground bar (13), the electric power module (4) including electric power members able to supply an electrical load via the power bars (12) of the installation (1),
**characterized in that** it comprises a power electrical connection system (8) for connecting an electric power module (4) according to any of claims 1 to 3.

5. The removable electric power module (4) according to claim 4, further comprising a hatch (9) for accessing said power connection/disconnection system (8) and a sensor (11) for detecting the opening and closing of said access hatch (9).

6. The removable electric power module (4) according to any of claims 4 or 5, further comprising a high abutment sensor configured to detect the positioning of the connection/disconnection system (8) in a position in which all the connectors (160, 165, 168) of the connection/disconnection system (8) are connected to the corresponding elements of the connection box (7) of the installation (1).

7. A high-power modular uninterruptable power supply installation (1) comprising a structure defining housings for accommodating (3) removable electric modules (4), each housing (3) being equipped with means for guiding a removable electric module (4) and with a power connection box (7), **characterized in that** it comprises at least one removable electric power module (4) according to any of claims 4 to 6.

8. The installation (1) according to claim 7, wherein the electric power module (4) comprises casters (6) mounted on a rack 5 of the module (4) to cooperate with the means for guiding a housing for accommodating (3) the installation (1).

9. A method for electrically connecting an electric power module (4) in a high-power modular uninterruptable power supply installation (1) according to any of claims 7 or 8, the installation (1) being powered on, **characterized in that** it comprises an actuation (705) of a device for translating (17) a set of connectors (16) successively causing, during the actuation, a connection (710) of a ground connector (165) of the module (4) to a ground bar (13) of the connection box (7), then a connection (715) of power connectors (160) of the module (4) to the power bars (12) of the connection box (7).

10. The electrical connection method according to claim 9, further comprising, during said actuation of the translation device (17), a connection (725) of a control connector (168) of the module (4) to a control terminal, following the connection (715) of the power connectors (160) of the module (4) to the power bars (12) of the connection box (7).

11. The electrical connection method according to any of claims 9 or 10, further comprising a detection (730) of end-of-stroke of the translation device (17), then an emission, by the installation, of a unique identifier to the control unit of the module (4).

12. The electrical connection method according to any of claims 9 to 11, wherein the actuator (10) is manually controlled by a user, and the method further comprises a detection (700) of the opening of the a hatch for accessing (9) the connection/disconnection system (8), the installation (1) delivering to the control unit of the electric module (4) via the control connector (168) a signal preventing the starting of the power members of the electric module (4) as long as the hatch for accessing (9) the connection/disconnection system is open.

13. The electrical connection method according to claims 11 and 12 taken in combination, further comprising, following the detection (730) of end-of-stroke of the translation device, a detection (735) of the closing of the hatch for accessing (9) the connection/disconnection system, then a command (740) for a test cycle of the electric module (4) before authorizing a starting of the power supply to the electric module (4), the test cycle including a check of the value of the input voltage, a check of the connections of the sensors, a check of the quality of the communication with the other electric modules (4) of the installation (1).

14. The electrical connection method according to claim 13, further comprising a command (745) to start the power members and a command to close a contactor in order to connect the power members to the power connectors (160) according to the result of the test cycle.

15. A method for electrically disconnecting an electric power module (4) in a high-power modular uninterruptable power supply installation (1) according to any of claims 7 or 8, the installation (1) being powered on, **characterized in that** it comprises an actuation (815) of a connector translation device (17) causing successively, during the actuation, a disconnection (825) of the power connectors (160) of the module (4) from the power bars (12) of the connection box (7), then a disconnection (830) of a ground connector (165) of the module (4) from a ground bar (13) of the connection box (7).

16. The electrical disconnection method according to claim 15, further comprising, before the actuation of the translation device (17), a detection (800) of an opening of the hatch for accessing (9) the connection/disconnection system (8) followed by a command (805) to stop the power members and a command to disconnect the power members from the power connectors (160) of the electric module (4) by the opening of a contactor.
